(19) Europäisches Patentamt
European Patent Office
Office européen des brevets

(11) **EP 4 787 419 A1**

(12) **EUROPEAN PATENT APPLICATION**

(43) Date of publication:
**05.08.2026 Bulletin 2026/32**

(21) Application number: **25174283.9**

(22) Date of filing: **05.05.2025**

(51) International Patent Classification (IPC):
**H01J 37/244** (2006.01)     **H01J 37/26** (2006.01)

(52) Cooperative Patent Classification (CPC):
**H01J 37/244;** H01J 2237/24445; H01J 2237/2448;
H01J 2237/2605

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **02.02.2025 KR 20250012832**

(71) Applicant: **Coxem Co., Ltd.
Daejeon 34025 (KR)**

(72) Inventors:
• **Hong, Jae Wan
08520 Seoul (KR)**

• **Kwak, Dong Hwa
35274 Daejeon (KR)**
• **Lee, Jun Hee
34090 Daejeon (KR)**
• **Kim, Young Gon
54609 Iksan-si (KR)**
• **Maeng, Jin Soo
51739 Changwon-si (KR)**

(74) Representative: **Habermann, Hruschka &
Schnabel
Patentanwälte
Montgelasstraße 2
81679 München (DE)**

(54) **SECONDARY ELECTRON DETECTOR USING A CONDUCTIVE ULTRA-THIN MEMBRANE PROVIDED IN AN ATMOSPHERIC PRESSURE ELECTRON MICROSCOPE**

(57)     The present invention relates to a secondary electron detector 100 in an atmospheric pressure electron microscope, wherein secondary electrons generated by irradiating a sample S with a high-energy electron beam are captured in an ultra-thin membrane 110 of e.g. graphene supported on an apertured 121 second thin membrane 120, and ionization of air or injection gas between the ultra-thin graphene membrane and the sample is generated by a voltage applied between the ultra-thin graphene membrane and the sample, and is greatly amplified by the avalanche effect, an ion current is displayed as an image on a monitor through an amplifier.

**FIG. 2**

EP 4 787 419 A1

## Description

Technical field

The present invention relates to a secondary electron detector using a conductive ultra-thin membrane provided in an atmospheric pressure electron microscope, and more specifically, to a secondary electron detector for an atmospheric pressure electron microscope in which secondary electrons generated when an electron beam is irradiated on a sample are captured by a ultra-thin graphene membrane, and an avalanche effect occurs in an air or gas layer due to a voltage applied between the ultra-thin graphene membrane and the sample to amplify a current between the ultra-thin graphene membrane and the sample, and this current is displayed as an image on a monitor through an amplifier.

This application claims priority based on Korean Patent Application No. 10-2025-0012832 filed on February 02, 2025, and all contents disclosed in the specification and drawings of the application are included in this specification.

Background Art

Atmospheric pressure electron microscope (A-SEM) refers to an electron microscope that observes a sample (specimen) located in an atmospheric pressure or low vacuum state rather than a high vacuum state. The atmospheric pressure electron microscope has higher resolution and a deeper depth of focus than an optical microscope, allowing for clearer observation of living biological samples.

The atmospheric pressure electron microscope includes a column having an internal space which is in a high vacuum state, a thin membrane installed at a lower end of the column to separate the internal space from an outside, and a sample stage installed below the thin membrane.

A distance (mean-free path: MFP) that electrons can move freely in the atmosphere without colliding with molecules is tens to hundreds of $\mu$m or less. The longer the MFP, the less electrons are scattered, so the stronger the signal and the smaller the noise, allowing for a high signal-to-noise ratio and high-quality images. Since the MFP is greatly affected by the number of molecules present in the path that electrons pass through, the higher the vacuum, the longer the MFP. Therefore, the inside of the column, which occupies most of the path that electrons pass through, must be maintained at high vacuum state, and a low vacuum or atmospheric pressure must be created near the sample only to minimize electron scattering. Therefore, high vacuum and low vacuum (or atmospheric pressure) are separated from each other by the thin membrane near the sample. The thin membrane serves to allow electrons having small size to pass through well, while preventing atoms much larger than the electrons from passing through.

The electrons generated from an electron gun pass through the internal space of the column without scattering, and are scattered by the air around the thin membrane and the sample, and are irradiated onto the sample. And, the electrons irradiated onto the sample generate backscattered electrons (BSE), secondary electrons (SE), and X-rays etc., among which the secondary electrons are detected by a secondary electron detector (SED). The secondary electrons (SE) have low energy due to inelastic scattering. Since the secondary electrons (SE) are generated on a surface of the sample, the difference between an incident angle and a reflection angle is large.

Accordingly, the secondary electron detector (SED) is usually located laterally at the lower end of the column. However, in the atmospheric pressure electron microscope, since a gap between the lower end of the column and the sample is very narrow, there is not enough space to install the secondary electron detector, and even if the secondary electron detector is installed, it is difficult to effectively capture the secondary electrons.

DISCLOSURE

Technical goals

The present invention has been proposed to solve the above problem, and a purpose of the present invention is to provide a secondary electron detector for an atmospheric pressure electron microscope in which secondary electrons generated when an electron beam is irradiated on a sample are captured in an ultra-thin graphene membrane, and an avalanche effect occurs in air or gas layer due to a voltage applied between the ultra-thin graphene membrane and the sample to amplify a current between the ultra-thin graphene membrane and the sample, and this current is displayed as an image on a monitor (display unit) through an amplifier.

Technical Solution

In order to achieve the above purposes, a secondary electron detector 100, 100a, 100b, 100c, 100d for an atmospheric pressure electron microscope according to a preferred embodiment of the present invention may include a substrate 101 that is electrically conductive and is installed at a lower end of a column 10 and has a through-hole part 102 formed in a center through which a high-energy electron beam passes; and a first thin membrane 110 that is installed at the substrate 101 to hermetically seal the through-hole part 102 and maintains a high vacuum inside the column 10 while blocking air but allowing the high-energy electron beam to pass through, and capable of capturing low-energy secondary electrons, and is electrically conductive and has a thickness of several nm or less.

A voltage $V_b$ is applied between the first thin membrane 110 and the sample S, with a positive voltage connected to the first thin membrane 110 and a negative voltage connected to the sample S or grounded. The electron beam is irradiated to the sample S, and the generated low-energy secondary electrons are captured by the first thin membrane 110, and ion charges are generated and amplified between the first thin membrane 110 and the sample S by the avalanche effect, and a large current is generated, and this current is displayed as an image of the sample S on the display unit.

A second thin membrane 120 is attached to a front surface of the substrate 101 to cover the through-hole part 102, and a plurality of through-holes 121 may be formed at least in a portion corresponding to the through-hole part 102 in the second thin membrane 120. The first thin membrane 110 covers the second thin membrane 120 to hermetically seal the through-holes (121). The first thin membrane 110 is an ultra-thin membrane made of graphene or a 2D material, and the second thin membrane 120 has a thickness of 20nm to 1μm and may have a thickness thicker than the first thin membrane 110. The second thin membrane 120 supports the first thin membrane 110, and acts as a window frame.

It is preferable that the distance d between an upper surface of the sample S and the first thin membrane 110 is 50μm to 500μm.

An electrical insulating plate or an electrical insulating PCB 130 is installed on a back surface of the substrate 101, and a metal pattern is partially formed on the front or back surface of the insulating plate or insulating PCB 130 so that it can be electrically connected to an amplifier.

An adapter 140 for fastening the substrate 101 to the lower end of the column may be installed on the back surface of the substrate 101. A groove 141 is formed on a surface of the adapter 140 that faces the substrate 101, and a predetermined conductive adhesive 142 is filled in the groove 141, thereby facilitating electrical connection between the adapter 140 and the substrate 101.

The first thin membrane 110 may be made by depositing graphene on the second thin membrane 120.

## Advantageous Effects

The secondary electron detector for an atmospheric pressure electron microscope according to the present invention can effectively capture secondary electrons because the ultra-thin graphene membrane (the first thin membrane) is located directly above the sample and acts as a positive electrode. That is, when an electron beam is irradiated on the sample, secondary electrons generated are captured by the ultra-thin graphene membrane (first thin membrane), and an avalanche effect occurs due to a voltage applied between the ultra-thin graphene membrane and the sample, causing a large current between the ultra-thin graphene membrane and the sample, and this current is displayed more clearly as an image on a monitor through an amplifier.

## BRIEF DESCRIPTION OF THE DRAWINGS

FIG. 1 is a drawing showing main configurations of an atmospheric pressure electron microscope equipped with a secondary electron detector according to the first embodiment of the present invention.
FIG. 2 is a cross-sectional view showing a configuration of the secondary electron detector of FIG. 1.
FIG. 3 is a cross-sectional view showing a secondary electron detector according to the second embodiment of the present invention.
FIG. 4 is a cross-sectional view showing a secondary electron detector according to the third embodiment of the present invention.
FIG. 5 is a cross-sectional view showing a secondary electron detector according to the fourth embodiment of the present invention.
FIG. 6 is a plan view showing the secondary electron detector of FIG. 5.
Fig. 7 is a front view showing the secondary electron detector of Fig. 5.
Fig. 8 is a cross-sectional view showing the secondary electron detector according to the fifth embodiment of the present invention.

## DETAILED DESCRIPTION

Hereinafter, the present invention will be described in detail with reference to the attached drawings. Prior to this, terms or words used in this specification and claims should not be interpreted as limited to their usual or dictionary meanings, and should be interpreted as meanings and concepts that conform to the technical idea of the present invention based on the principle that the inventor can appropriately define the concept of the term in order to explain his or her own invention in the best way. Therefore, the embodiments described in this specification and the configurations illustrated in the drawings are merely embodiments of the present invention and do not represent all of the technical idea of the present invention, so it should be understood that there may be various equivalents and modified examples that can replace them at the time of filing this application.

In the drawings below, the same reference numerals represent the same or substantially the same components.

[First Embodiment]

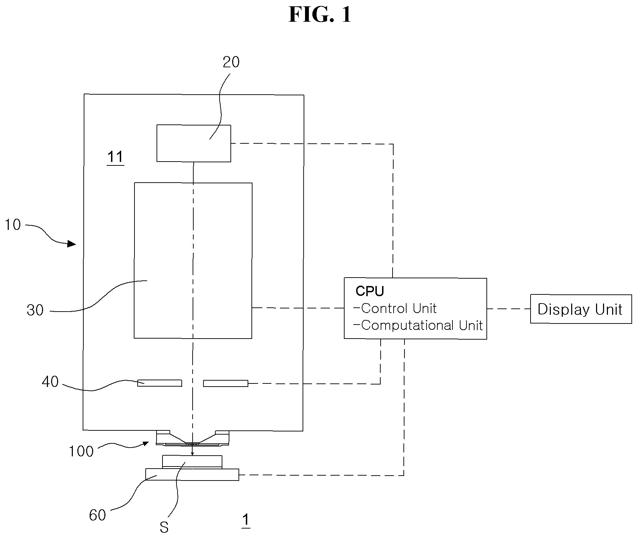

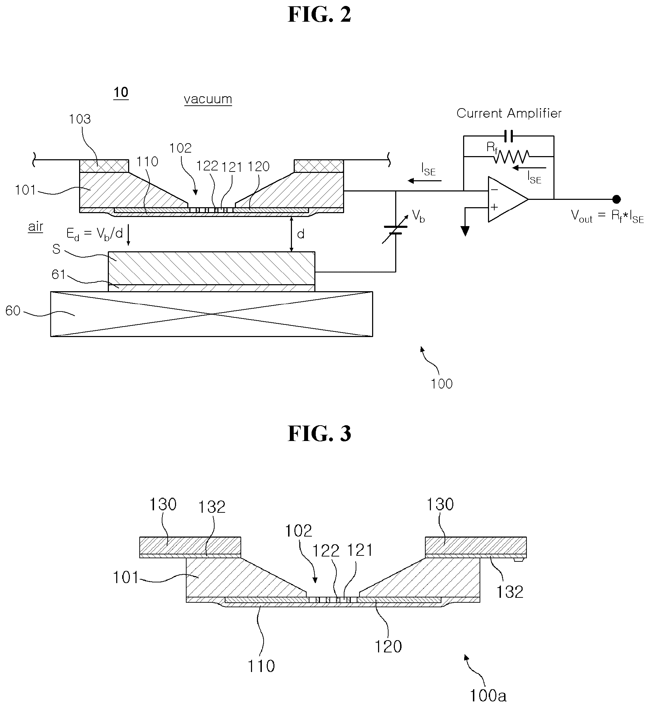

FIG. 1 is a drawing showing main configurations of an atmospheric pressure electron microscope equipped with a secondary electron detector according to the first embodiment of the present invention, and FIG. 2 is a cross-sectional view showing the secondary electron detector. In FIG. 1, a dotted line indicates a path through which various electrical control signals, data, images, etc. are transmitted, and a dash-double dotted line indicates a path through which high-energy electrons (electron beams) generated from an electron gun move to a sample S. In addition, a distance between the sample S and an ultra-thin graphene membrane 110, a width and thickness of the membrane 110, 120, etc. are expressed to be exaggerated compared to actual values in the drawing, which is for the purpose of helping understanding.

As shown in the drawing, the atmospheric pressure electron microscope may include a column 10, a secondary electron detector 100 including a conductive ultra-thin membrane, a sample stage 60, a CPU (central processing unit), and a display unit.

The column 10 has a high vacuum space 11 therein. Inside the column 10, an electron gun 20 that generates electrons, an electron optical system 30 including a focusing lens, an objective lens, a deflector, etc., and a BSD (Back Scattered Electron Detector, 40) etc. can be installed.

The electron optical system 30 can change a path of electron beam according to a control signal transmitted from the control unit of the central processing unit (CPU), and preferably, this control signal can be linked to a movement of the sample stage 60. For example, a deflector (or scanner) inside the electron optical system 30 can control the movement path of the electron beam so that the electrons pass through a specific point of the ultra-thin graphene membrane (120, first thin membrane).

The BSD (40) may be installed below the electro-optical system (30), but is not necessarily limited thereto. The BSD 40 detects BSEs (back scattered electrons) and transmits a signal of the BSEs to the central processing unit, and the computational unit of the central processing unit processes the transmitted signal and generates an image of the sample and outputs it to the display unit.

The secondary electron detector 100 includes a substrate 101 installed at a lower end of the column 10, the first and second thin membranes 110, 120 installed on the substrate 101, and a voltage ($V_b$) applied between the first thin membrane 110 and the sample S. In the drawing, an anode of the voltage ($V_b$) is connected to the substrate 101, but may be connected to the first thin membrane 110. In the drawing, a cathode of the voltage ($V_b$) is connected to the sample (S), but may be grounded.

The substrate 101 is made of an electrically conductive material. The electrically conductive material may be a wafer made of silicon (Si), but is not necessarily limited thereto. A through-hole part 102 may be formed in a center of the substrate 101, and an electrical insulating plate 103 may be installed at an edge of the substrate 101. The through-hole part 102 is a hole part that penetrates the substrate 101 and may have various shapes such as a square or a circle. In addition, the electrical insulating plate 103 is a circular ring installed on a back surface of the substrate 101 and blocks a current of the substrate 101 from flowing to the column 10.

The first and second thin membranes 110, 120 are installed (or attached) to cover a front surface of the substrate 101 to hermetically seal the through-hole part 102. In the drawing, the thin membranes are illustrated as being made of the first and second thin membranes 110, 120, but may also be made of only the first thin membrane 110.

The second thin membrane 120 includes a grid 122 and a through hole 121 formed at least in a portion corresponding to the through hole part 102. The second thin membrane 120 is installed so as to cover the through hole part 102 and its surroundings in a front surface of the substrate 101, but it is preferable not to cover a part of the front surface of the substrate 101, for example, an edge of the front surface. This is to ensure that at least a part of the first thin membrane 110 is in direct contact with the substrate 101, so that the first thin membrane 110 is electrically connected to the substrate 101 which is electrically conductive.

The through hole 121 is a hole formed so as to penetrate the second thin membrane 120, and the grid 122 is a portion of the second thin membrane 120 between the through holes 121, and the grid 122 supports the first thin membrane 110. That is, the grid 122 is a kind of window frame supporting the first thin membrane 110. The through hole 121 is a hole through which electrons pass, and electrons hardly pass through the grid 122. So, the grid 122 only serves to support the first thin membrane 110. Through holes 121 of the same shape may be repeatedly formed and patterned. The through hole 121 can be patterned using photolithography and reactive ion etching.

Preferably, the second thin membrane 120 is a membrane made of $SiN_x$ (e.g., $Si_3N_4$) and has a thickness of 20nm or more and 1$\mu$m or less (20nm ~ 1$\mu$m), and has a thickness thicker than the first thin membrane 110 (ultra-thin membrane).

The second thin membrane 120 can have an area of 3mm in width $\times$ 3mm in length, and can be formed on the substrate 101 by deposition.

The first thin membrane 110 is installed on the second thin membrane (120) and the substrate 101 to hermetically seal the through hole 121. The first thin membrane 110 blocks air so that the high vacuum is maintained inside the column 10, but allows high-energy electron beams (electrons) to pass through. In addition, the first thin membrane 110 can capture low-energy secondary electrons.

The first thin membrane 110 is an ultra-thin membrane thinner than the second thin membrane 120, and can be made of graphene or a two-dimensional material (2D material) with high electron transmittance. Usually, the thickness of the first thin membrane 110 is an integer multiple of a single layer of graphene or other 2D material, and considering resolution and signal strength, a thickness in the range of 1 to 10 nm is preferable. If the thickness is less than 1 nm, the first thin membrane (110) is easily damaged, and if the thickness exceeds 10 nm, the image is not clear.

In an existing atmospheric pressure electron microscope, a thin $Si_3N_4$ membrane without a through hole 121 was used, but it was difficult to make the thin $Si_3N_4$ membrane thin and uniform to a few nm (nano meter). Because of this, the existing atmospheric pressure electron microscopes had no choice but to use thick membranes of 20 nm or more for strength, which limited the resolution and clarity of the images. Graphene has a single layer thickness of 0.2 nm, and can be made uniformly by stacking multiple layers to a few nm. Graphene has been used to wrap samples for observing them in a vacuum, and recent studies have shown that thin membranes made of graphene provide an electron transparent window with a contrast reduction of only 2%. Therefore, when the ultra-thin graphene membrane (110, first thin membrane) is formed (deposited) on the second thin membrane (120, $Si_3N_4$ thin membrane) with through-holes 121 and used as an electron transparent window of an atmospheric pressure electron microscope, the signal/noise ratio is improved by five times compared to using the $Si_3N_4$ thin membrane, and accordingly, high contrast can be obtained in backscattering, surface imaging modes of transmission electron microscopy and general electron microscope (SEM). In addition, the ultra-thin graphene membrane (first thin membrane, 110) has excellent electron transmittance, therefore deterioration and contamination by electron beams are much reduced compared to the $Si_3N_4$ thin membrane, and mechanical durability is also excellent.

Meanwhile, the secondary electron detector 100 according to the present invention has a characteristic of using the first thin membrane (110, ultra-thin graphene membrane) not only to separate the high vacuum inside the column and the external atmospheric space, but also to capture secondary electrons. That is, the present invention uses the ultra-thin graphene membrane 110 as an electrode because the ultra-thin graphene membrane 110 has excellent electrical conductivity. This will be described below.

When a predetermined voltage ($V_b$) is applied between the first thin membrane 110 and the sample S, and a positive voltage is connected to the first thin film 110 and a negative voltage is connected to the sample S, an electron beam generated from an electron gun 20 is irradiated on the sample S to generate secondary electrons, and air or an injection gas (e.g., He gas) between the sample S and the first thin film 110 is ionized by the avalanche effect, and the ionization is accelerated by a chain reaction, so that a large current ($I_{SE}$) flows between the first thin film 110 and the sample S. Then, this current ($I_{SE}$) is amplified by a current amplifier and is clearly displayed as an image of the sample S on a display unit (monitor, etc.).

In Fig. 2, $V_{out}$ represents a voltage amplified by the current amplifier. $V_{out}$ can be calculated by the following equation.

[Formula]

$$V_{out} = R_f \times I_{SE}$$

And, when the voltage ($V_b$) is applied across a distance (d), an electric field ($E_d$) as shown in the equation below is generated between the first thin membrane 110 and the sample S.

[Formula]

$$E_d = V_b/d$$

The voltage ($V_b$) may be tens to hundreds of volts, and the distance (d) between the upper surface of the sample S and the first thin membrane 110 may be $50\mu m$ to $500\mu m$. And, an electric insulating plate 61 made of a material having high insulation may be provided between the sample S and the sample stage 60 to prevent leakage current.

It is preferable to periodically wash the electric insulating plate 61 to minimize the leakage current.

[Embodiments 2 to 5]

FIG. 3 is a cross-sectional view showing a secondary electron detector according to a second embodiment of the present invention.

The secondary electron detector 100a has an insulating PCB 130 installed on a back surface (upper surface) of the substrate 101, a copper pattern 132 formed only on a lower surface of the insulating PCB 130, and the copper pattern 132 on the lower surface of the PCB 130 and the back surface (upper surface) of the silicon substrate 101 are directly connected electrically by a conductive epoxy or indium thin membrane, and the copper pattern 132 is electrically connected to the current amplifier. The insulating PCB 130 is made of a material having high insulating properties to prevent leakage current between the substrate 101 and the column 10.

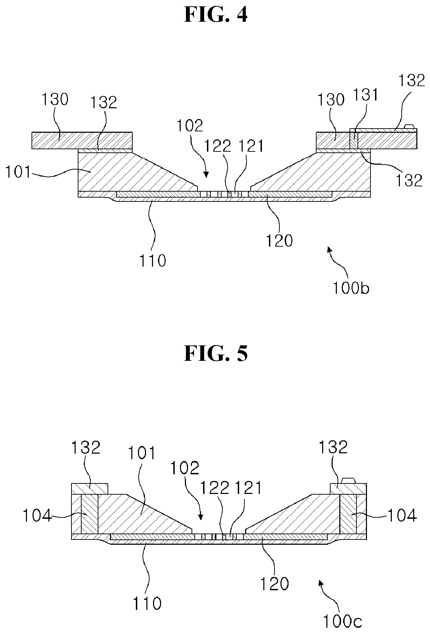

FIG. 4 is a cross-sectional view showing a secondary electron detector according to the third embodiment of the present invention.

The secondary electron detector 100b has an insulating PCB 130 installed on the back surface of the substrate 101, and current $I_{SE}$ flows to the current amplifier through a via hole 131 penetrating the insulating PCB 130. A copper pattern (132, Cu pattern) is formed on both surfaces of the insulating PCB 130, and the upper surface and the lower surface are electrically connected through the via hole 131. Therefore, the current $I_{SE}$ sequentially passes through the first thin membrane 110, the substrate 101, the copper pattern 132, a copper of the via hole 131, and the copper pattern 132 and then flows to the current amplifier. This configuration has an advantage of making it easy to connect a wire (not shown in FIG. 4) connecting the current amplifier and the secondary electron detector which is very close to the sample S. That is, in the secondary electron detector 100a of FIG. 3, since a wire (not shown in Fig. 3) connected to the copper pattern 132 is located very close to the sample (S, not shown in Fig. 3), there is a concern that it may interfere with the sample S, but the secondary electron detector (100b) of Fig. 4 solves this problem.

Meanwhile, although not shown in FIG. 4, an electrical insulation plate (103 of Fig. 2) or an insulating epoxy for fixation may be installed on the copper pattern (132, Cu pattern) of the insulating PCB 130. The electrical insulation plate 103 or the insulating epoxy blocks the current ($I_{SE}$) from flowing to the column 10 or blocks the leakage current.

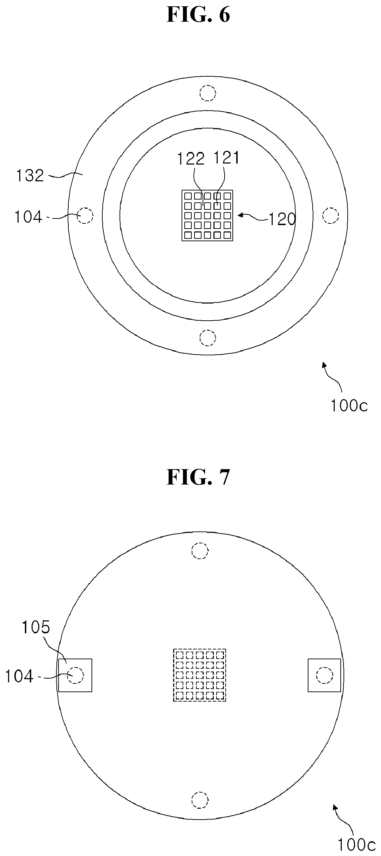

FIG. 5 is a cross-sectional view showing a secondary electron detector according to the fourth embodiment of the present invention, FIG. 6 is a plan view of FIG. 5, and FIG. 7 is a front view of FIG. 5.

The secondary electron detector 100c has differences in that a via hole (TSV, Through Silicon Via, 104) penetrating the substrate 101 is formed, the via hole 104 is filled with copper, and a copper pattern 132 is formed on a top of the via hole 104. The copper pattern 132 is electrically connected to the copper of the via hole 104. Therefore, the current ($I_{SE}$) flows sequentially through the first thin membrane 110, the copper of the via hole 104, and the copper pattern 132.

Compared to the secondary electron detector 100b of FIG. 4 where the current ($I_{SE}$) flows through a high-resistance silicon substrate 101, the secondary electron detector 100c has an advantage of minimizing noise or leakage current by allowing the current ($I_{SE}$) to flow through the low-resistance Cu via 104.

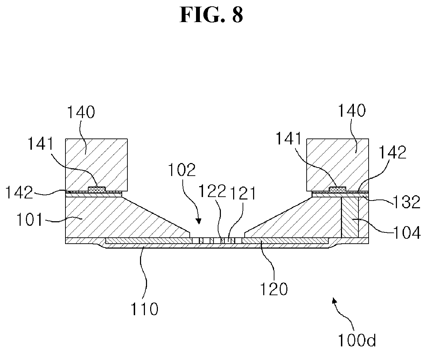

FIG. 8 is a cross-sectional view showing a secondary electron detector according to the fifth embodiment of the present invention.

The secondary electron detector 100d further has a ring-shaped adapter 140 installed on a back surface (upper surface) of the substrate 101, and a groove 141 is formed on a front surface (the surface facing the substrate 101 among the two sides of the adapter) of the adapter 140, and an adhesive 142 is filled in the groove 141 to maintain airtightness. The groove 141 can be formed in a ring shape on the front surface (lower surface) of the adapter 140.

The adapter 140 is a device that allows the substrate 101 to be attached and detached to the column 10 and seals the inside of the column 10, and its configuration is well known, so a detailed description is omitted here. The adapter 140 may be made of an insulator.

When indium is used as the adhesive 142, a ring-shaped copper pattern 132 is locally formed on an insulator installed on the front (lower surface) of the adapter 140 to ensure sealing and prevent electrical short-circuiting between the secondary electron detector and the column 10. In this case, the current ($I_{SE}$) flows sequentially through the first thin membrane 110, the copper of the via hole 104, and the copper pattern 132.

On the other hand, when using an insulating epoxy instead of the indium, an insulating plate for insulation and a copper pattern 132 on the insulating plate are not necessary.

## Claims

1. A secondary electron detector of an atmospheric pressure electron microscope for detecting a secondary electron generated from a sample S, the secondary electron detector comprising:

   a substrate 101 installed at a lower end of a column 10 of the atmospheric pressure electron microscope, and a through-hole part 102 is formed in a center of the substrate 101 through which a high-energy electron beam passes;
   a second thin membrane 120 attached to a front surface of the substrate 101 to cover the through-hole part 102, and having a plurality of through holes 121 formed therein; and,
   a first thin membrane 110 installed on the second thin membrane 120 to hermetically seal the through holes 121, and blocks air so that a high vacuum inside the column 10 is maintained, but allows the high-energy electron beam to pass through, and can capture low-energy secondary electrons, and is electrically conductive, and is thinner than the second thin membrane 120;
   wherein a voltage ($V_b$) is applied between the first thin membrane 110 and the sample S, and a positive voltage is connected to the first thin membrane 110,
   wherein the secondary electrons generated when the electron beam is irradiated to the sample S are captured by the first thin membrane 110, and an ion charge is generated and amplified between the first thin membrane 110 and the sample S by the avalanche effect to generate a large current flow, and the current is displayed as an image of the sample S on a display unit.

2. The secondary electron detector according to claim 1,

   wherein the first thin membrane 110 is an ultra-thin membrane made of graphene or a 2D material and has a thickness of 1 to 10 nm,
   wherein the second thin membrane 120 has a thickness of 20nm to 1μm and supports the first thin membrane 110.

3. The secondary electron detector according to claim 1,
wherein a distance (d) between an upper surface of the sample S and the first thin membrane (110) is 50μm to 500μm.

4. The secondary electron detector according to any one of claims 1 to 3,
wherein an electrical insulation plate or an electrical insulation PCB 130 is installed on a back surface of the substrate 101, and a metal pattern is partially formed on a front or back surface of the electrical insulation plate or the electrical insulation PCB 130 so as to be electrically connected to an amplifier.

5. The secondary electron detector according to any one of claims 1 to 3,

   wherein an adapter 140 is installed on a back surface of the substrate 101 for fastening the substrate 101 to the lower end of the column, a groove 141 is formed on a surface of the adapter 140 facing the substrate 101, and a predetermined adhesive 142 is filled in the groove 141.

6. The secondary electron detector according to claim 1,
wherein the first thin membrane 110 is made by depositing graphene on the second thin membrane 120.

7. An atmospheric pressure electron microscope including the secondary electron detector of any one of claims 1 to 3.

# FIG. 1

20

11

10

30

40

100

60

S

1

CPU
-Control Unit
-Computational Unit

Display Unit

## FIG. 2

## FIG. 3

**FIG. 4**

**FIG. 5**

## FIG. 6

## FIG. 7

**FIG. 8**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/117232 A1 (SHACHAL DOV [IL] ET AL) 1 May 2014 (2014-05-01) | 1,3,6,7 | INV. H01J37/244 |
| Y | * abstract *<br>* paragraphs [0005] - [0012], [0037] - [0189]; figures 1,2,11,25 * | 2 | H01J37/26 |
| Y | US 2024/038483 A1 (PEDRAZO TARDAJOS ADRIAN [BE] ET AL) 1 February 2024 (2024-02-01)<br>* abstract *<br>* paragraphs [0022] - [0149]; figures 1-9 * | 2 | |
| Y | US 2020/240933 A1 (YUK JONGMIN [KR] ET AL) 30 July 2020 (2020-07-30)<br>* abstract *<br>* paragraphs [0054] - [0099]; figures 1-11 * | 2 | |

**TECHNICAL FIELDS SEARCHED (IPC)**

H01J

The present search report has been drawn up for all claims

| Place of search | Date of completion of the search | Examiner |
|---|---|---|
| The Hague | 28 October 2025 | Lang, Thomas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

**Application Number**

EP 25 17 4283

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-3, 6, 7

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

The Search Division considers that the present European patent application does not comply with the requirements of unity of invention and relates to several inventions or groups of inventions, namely:

1. claims: 1-3, 6, 7

A secondary electron detector of an atmospheric pressure electron microscope for detecting a secondary electron generated from a sample, the secondary electron detector comprising:
a substrate installed at a lower end of a column of the atmospheric pressure electron microscope, and a through-hole part is formed in a center of the substrate through which a high-energy electron beam passes;
a second thin membrane attached to a front surface of the substrate to cover the through-hole part, and having a plurality of through holes formed therein; and,
a first thin membrane installed on the second thin membrane to hermetically seal the through holes, and blocks air so that a high vacuum inside the column is maintained, but allows the high-energy electron beam to pass through, and can capture low-energy secondary electrons, and is electrically conductive, and is thinner than the second thin membrane;
wherein a voltage is applied between the first thin membrane and the sample, and a positive voltage is connected to the first thin membrane,
wherein the secondary electrons generated when the electron beam is irradiated to the sample are captured by the first thin membrane, and an ion charge is generated and amplified between the first thin membrane and the sample by the avalanche effect to generate a large current flow, and the current is displayed as an image of the sample on a display unit (claim 1),
wherein the first thin membrane is an ultra-thin membrane made of graphene or a 2D material and has a thickness of 1 to 10 nm,
wherein the second thin membrane has a thickness of 20 nm to 1 mu.m and supports the first thin membrane (claim 2).
---

2. claim: 4

The secondary electron detector according to at least claim 1, wherein an electrical insulation plate or an electrical insulation PCB is installed on a back surface of the substrate, and a metal pattern is partially formed on a front or back surface of the electrical insulation plate or the electrical insulation PCB so as to be electrically connected to an amplifier.
---

3. claim: 5

The secondary electron detector according to at least claim

Europäisches
Patentamt

European
Patent Office

Office européen
des brevets

**LACK OF UNITY OF INVENTION
SHEET B**

The Search Division considers that the present European patent application does not comply with the
requirements of unity of invention and relates to several inventions or groups of inventions, namely:

1, wherein an adapter is installed on a back surface of the
substrate for fastening the substrate to the lower end of
the column,a groove is formed on a surface of the adapter
facing the substrate, and a predetermined adhesive is filled
in the groove.

---

page 2 of 2

## ANNEX TO THE EUROPEAN SEARCH REPORT
## ON EUROPEAN PATENT APPLICATION NO.

EP 25 17 4283

This annex lists the patent family members relating to the patent documents cited in the above-mentioned European search report.
The members are as contained in the European Patent Office EDP file on
The European Patent Office is in no way liable for these particulars which are merely given for the purpose of information.

28-10-2025

| Patent document cited in search report | | Publication date | Patent family member(s) | | Publication date |
|---|---|---|---|---|---|
| US 2014117232 | A1 | 01-05-2014 | US | 2014117232 A1 | 01-05-2014 |
| | | | US | 2015243475 A1 | 27-08-2015 |
| US 2024038483 | A1 | 01-02-2024 | EP | 4012744 A1 | 15-06-2022 |
| | | | EP | 4260356 A2 | 18-10-2023 |
| | | | US | 2024038483 A1 | 01-02-2024 |
| | | | WO | 2022122985 A2 | 16-06-2022 |
| US 2020240933 | A1 | 30-07-2020 | KR | 20200092549 A | 04-08-2020 |
| | | | US | 2020240933 A1 | 30-07-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020250012832